# EUROPEAN PATENT SPECIFICATION

(11) **EP 1 681 765 B1**
(45) Date of publication and mention of the grant of the patent: **02.12.2009**
(21) Application number: 05078000.6
(22) Date of filing: 27.12.2005
(51) Int. Cl.: H03G 3/30

(54) **Audio automatic volume control**
Automatische Lautstärkenregelung
Commande automatique du volume des signaux audio

(30) Priority: 13.01.2005 US 35208
(43) Date of publication of application: 19.07.2006
(73) Proprietor: Delphi Technologies, Inc., Troy, MI 48007 (US)
(72) Inventor: Myers, Bruce A., Kokomo, IN 46901 (US)
(74) Representative: Denton, Michael John

(56) References cited:
- EP-A- 0 669 711
- EP-A- 0 899 164
- EP-A- 1 067 680
- EP-A1- 0 580 157
- WO-A-99/17442
- DE-A1- 4 237 005
- JP-A- 3 001 727
- JP-A- 55 061 116
- US-A- 3 873 921
- US-A1- 2004 146 167
- US-A1- 2004 218 514
- US-B1- 6 473 604
- PATENT ABSTRACTS OF JAPAN vol. 017, no. 230 (E-1361), 11 May 1993 (1993-05-11) & JP 04 361413 A (MITSUBISHI ELECTRIC CORP), 15 December 1992 (1992-12-15)

## Description

### TECHNICAL FIELD

The present invention relates generally to an audio control system and, more particularly, to a system for controlling audio volume based on a selected audio signal source.

### BACKGROUND OF THE INVENTION

Existing audio systems often include a plurality of audio signal sources from which a user may select to supply an audio signal to control an output speaker. Large variations in output levels may occur when the audio signal source is changed by the user, thereby resulting in large variations in initial speaker volume. For example, such audio systems do not effectively compensate for the potential large change in audio volume from a weak radio station to a compact disk (CD) player. This problem is also noticeable when switching between weak and strong radio stations. These large variations in speaker volume can generate discomfort for the listener and may require the listener to manually adjust the volume for each station or audio source selected.

As noted above, in order to compensate for large variations in speaker volume when changing audio signal sources, the user may manually adjust the current volume control setting. Alternatively, the signal strength supplied to the speakers could be measured and the volume adjusted in response thereto. However, normal variations in music dynamics would cause variations in speaker signal strength. As such, any automatic control based on speaker signal strength would likely eliminate the effect of normal musical dynamics and significantly reduce the quality of the musical selection.

A further alternative is to measure the incoming wireless signal strength and adjust the volume based on the current volume control setting. However, normal variations in signal strength make this difficult and wireless signal strength does not apply to CD or cassette tape audio source signals.

For automobile applications, the volume could be changed based upon the speed of the vehicle. While this method is known in the art, it does not solve the problem of large variations in speaker volume when the audio signal source is changed.

It is also known to adjust volume based on the time of dusk and dawn for a given day, to account for variations in radio frequency strength during different times of the day. However, this does not solve the basic problem of audio volume control detailed herein.

US-B1-6473604 discloses a system and method which provides matching of output levels for a plurality of receiver input sources. The system includes an output device, audio signal sources, a source selector, a memory, and a controller configured to identify the audio source and retrieve stored volume settings. US 2004/218514 discloses an audio system including a key input section and a microcomputer, and enables playback volume level control that will meet the demand of a user. EP-A1-0580157 , discloses an apparatus to facilitate volume control for route aural guidance, wherein supplying a guidance voice to a loud speaker, voice control section disconnects a loud speaker from audio and outputs the guidance voice through the loud speaker, and a volume control screen is displayed on a display section where the user adjust the volume by touching the screen.

### SUMMARY OF THE INVENTION

According to an illustrative embodiment of the present invention, an audio volume control system includes an output device, a plurality of audio signal sources, and a source selector coupled to the plurality of audio signal sources and configured to connect one of the audio signal sources to the output device in response to input from a user. A controller is coupled to the output device and is configured to identify the audio signal source connected to the output device. A memory is configured to store the identity of the audio signal source connected to the output device and an output volume level of the output device as a stored volume setting for the audio signal source. The controller is further configured to retrieve the stored volume setting for the audio signal source, and control the output volume level of the output device in response to the stored volume setting.

The audio volume control system includes an audio signal source, a volume selector configured to control the output volume level from an audio signal supplied by the audio signal source in response to input from a user, and a processor configured to identify the audio signal source and the output volume level of the audio signal. A clock is in communication with the processor, wherein the processor is configured to associate the output volume level of the audio signal with the audio signal source after the clock has counted a predetermined number of increments.

According to yet another illustrative embodiment of the present invention, a method of automatically controlling the volume produced by an audio system includes selecting a first audio signal source configured to generate a first audio signal, and identifying the first audio signal source. The method further includes the step of controlling an output volume level of an output device in response to a first stored volume setting associating the first audio signal source with a first output volume level. The method also includes the steps of selecting a second audio signal source configured to generate a second audio signal, identifying the second audio signal source, and controlling an output volume level of the output device in response to a second stored volume setting associating the second audio signal source with a second output volume level.

### BRIEF DESCRIPTION OF THE DRAWINGS

The above-mentioned and other features and objects of this invention, and the manner of attaining them, will become more apparent and the invention itself will be better understood by reference to the following description of embodiments of the invention taken in conjunction with the accompanying drawings, wherein:
Figure 1 is a block diagram illustrating various communication links within the audio volume control system in accordance with an illustrative embodiment of the present invention;
Figure 2 is a flow chart of an illustrative method of operation for applying a volume setting in accordance with the audio volume control system of Figure 1;
Figure 3 is a flow chart of an illustrative method of operation for storing a volume setting in accordance with the audio volume control system of Figure 1; and
Figure 4 is a illustrative embodiment look-up table of stored volume settings for use in connection with the audio volume control system of Figure 1.

Corresponding reference characters indicate corresponding parts throughout the several views. Although the drawings represent embodiments of the present invention, the drawings are not necessarily to scale and certain features may be exaggerated in order to better illustrate and explain the present invention. The exemplifications set out herein illustrate embodiments of the invention in several forms and such exemplification is not to be construed as limiting the scope of the invention in any manner.

### DESCRIPTION OF THE PREFERRED EMBODIMENTS

The embodiments discussed below are not intended to be exhaustive or limit the invention to the precise forms disclosed in the following detailed description. Rather, the embodiments are chosen and described so that others skilled in the art may utilize their teachings.

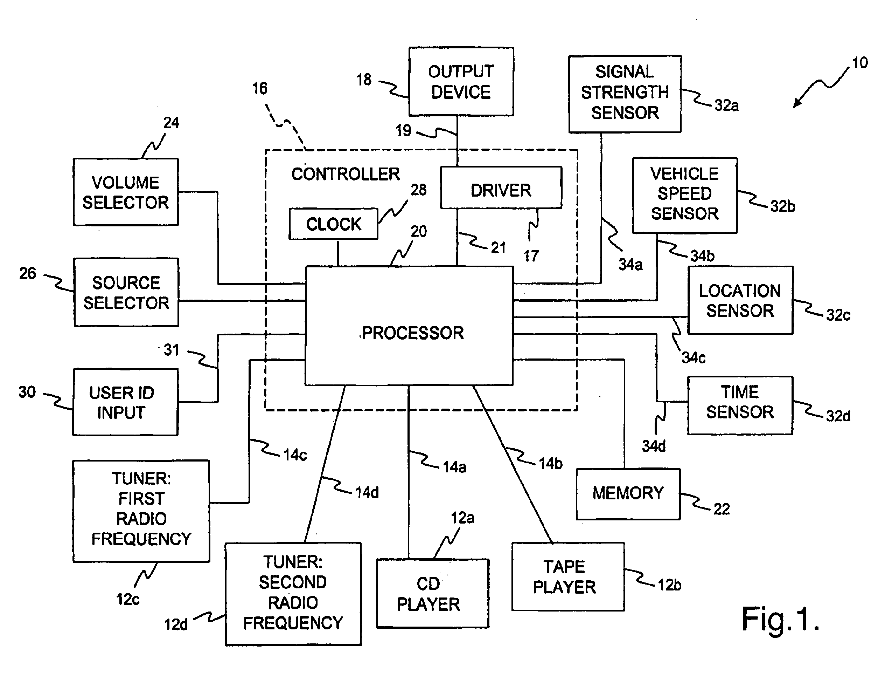

Referring initially to Figure 1, an audio volume control system 10 according to an illustrative embodiment of the present invention includes a plurality of audio signal sources 12 each configured to generate an audio signal 14. The audio signal sources 12 may include conventional audio devices such as a compact disk (CD) player 12a and a cassette tape player 12b. Similarly, the audio signal sources may include the plurality of radio stations or frequencies received by a conventional radio or tuner. More particularly, as illustrated in Figure 1, each frequency received by the tuner comprises a separate and distinct audio signal source 12. As such, a first radio frequency 12c comprises a audio signal source independent from a second radio frequency 12d. While only two radio frequencies 12c, 12d are shown in Figure 1, it should be appreciated that this does not limit the scope of the invention and that any number of radio frequencies may be utilized in connection with the audio volume control system 10. It should be further noted that additional audio signal sources 12, such as MP3 players and DVD players, may be used in connection with the system 10.

The audio signals 14a, 14b, 14c, 14d generated by the audio signal sources 12a, 12b, 12c, 12d are supplied to a controller 16. The controller 16 is coupled to a driver 17 which, in turn, is coupled to an output device 18, illustratively one or more conventional audio speakers. The driver 17 illustratively comprises a conventional output device driver circuit which provides the drive current or signal 19 required to generate audio power at the output device 18. In other words, the controller 16 controls the output volume level by adjusting the output 19 from the output device driver circuit 17 to the output device 18. In the illustrative embodiment, the controller 16 includes a processor 20 configured to transmit an output or control signal 21 to the driver 17 in response to the audio signal 14 from a selected one of the audio signal sources 12. In response to the control signal 21, the driver 17 causes the output device 18 to generate sound at a predetermined output volume level as further detailed herein. While Figure 1 illustrates the driver 17 as part of the controller 16, it should be appreciated that in alternative embodiments, the driver 17 may be part of the output device 18, or independent from both the processor 20 and the output device 18.

The processor 20 may be of conventional design, such as a CPU. The processor 20 illustratively couples to a memory 22 which may include, for example, volatile memory (such as RAM) and non-volatile memory (such as ROM, PROM, and EE PROM). The memory 22 may be utilized to provide instructions to the processor 20 and to store volume settings for the audio signal sources 12 as detailed below.

A volume selector 24, such as a conventional rotary control knob, is operably coupled to the processor 20. The volume selector 24 is configured to permit the user to manually control the drive signal 19 delivered to the output device 18, thereby controlling the output volume level of sound from the output device 18. A source selector 26 is operably coupled to the processor 20, and illustratively comprises a plurality of push buttons which may be manually depressed by the user to select one of the plurality of audio signal sources 12. The source selector 26 is configured to permit the user to place one of the audio signal sources 12 in communication with the output device 18 for receipt of an audio signal 14 thereby. Illustratively, a clock 28 is operably coupled with the processor 20 and may be of conventional design for counting a successive number of time increments. The clock 28 may form a portion of the controller 16 or be independent therefrom.

A user identification (ID) input 30 is illustratively provided in communication with the processor 20 and is configured to accept input in order to identify the current user or operator of the audio signal sources 12 and provide a signal 31 indicative thereof to the processor 20. The user ID input 30 may comprise conventional push buttons located adjacent the audio signal sources 12. Alternatively, the user ID input 30 may be integral with a conventional remote access device, such as a key fob, utilized with a vehicle. In such a case, multiple access devices are provided wherein each access device has a different identification code or signal associated with its user.

A plurality of external condition sensors 32 may be operably coupled to the processor 20 and are configured to detect conditions external to the audio signal sources 12. As illustrated in Figure 1, the external condition sensors may include a signal strength sensor 32a, which is configured to detect the strength of an incoming wireless signal, such as the first or second radio frequencies 12c, 12d. In response to a signal 34a from the signal strength sensor 32a, the processor 20 adjusts the output volume level of the output device 18. In other words, the processor 20 increases the volume of the output device 18 in response to a weak incoming wireless signal 12c, 12d, and decrease the volume of the output device 18 in response to a strong incoming wireless signal 12c, 12d.

Another illustrative external condition sensor comprises a vehicle speed sensor 32b, which detects the speed of a vehicle and provides a signal 34b indicative thereof to the processor 20. In response to the signal 34b, the processor 20 changes the output volume level of the output device 18. In other words, the processor 20 increase the volume of the output device 18 in response to increased vehicle speed, and decreases the volume of the output device 18 in response to decreased vehicle speed. A location sensor 32c may also be operably coupled to the processor 20 and is configured to detect the position of the audio signal sources 12 and provide a signal 34c indicative thereof to the processor 20. The processor 20, in turn, adjusts the volume setting based upon the detected location. For example, in order to compensate for greater distances of the tuner from the transmitter supplying the desired radio frequency 12c, 12d, the processor 20 increases the output volume level of the output device 18. Another illustrative external condition sensor comprises a time sensor 32d which supplies a signal 34d configured to cause the processor 20 to adjust the output volume level of the output device 18 based upon the time of day in order to compensate for different radio frequency strengths during different times of the day. It should be noted that the time sensor 32d may comprise the clock 28 or be independent thereof.

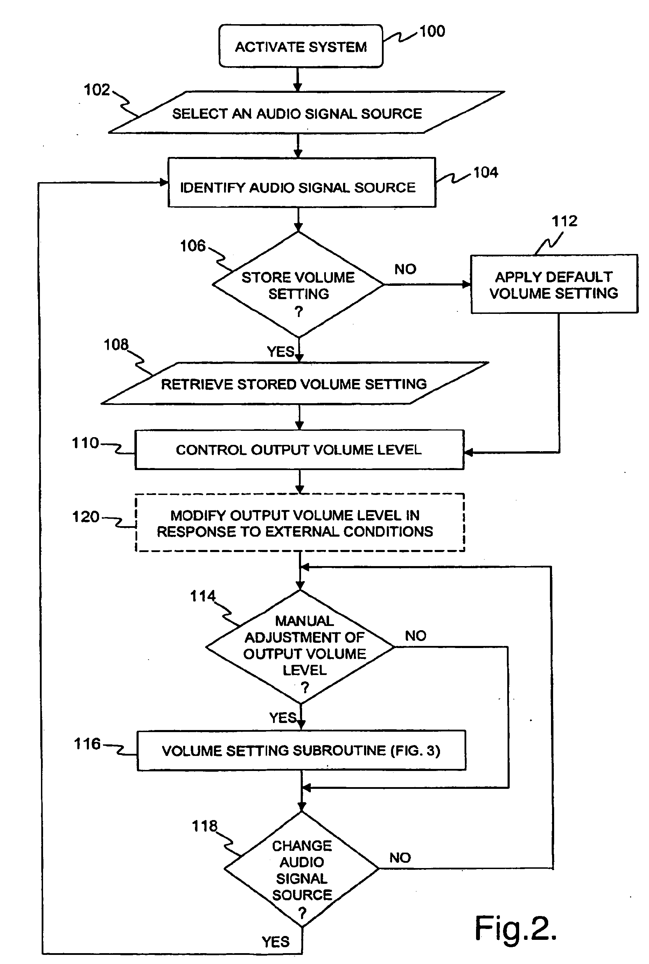

Turning now to Figure 2, operation of the audio volume control system 10 begins with a user activating the system 10 as shown in block 100. Next, the user selects an audio signal source 12 by operating the source selector 26 at block 102. The controller 16 identifies the audio signal source 12 at block 104 and then determines whether a volume setting for the source 12 has been stored in memory 22 at block 106. As detailed herein, each volume setting includes an output volume level and an associated audio signal source 12. If a volume setting has been stored in memory 22, the process continues to block 108 where the controller 16 retrieves the stored volume setting from memory 22. Next, the controller 16 controls the output volume level of the output device 18 at block 110.

If no stored volume setting is present at block 106, the controller 16 applies a default volume setting at block 112. In one embodiment, the default volume setting is a null value for the output volume levels for all audio signal sources 12. In an alternative embodiment, the default volume setting for each audio signal source 12 is an initial default output volume level stored in memory 22, which may be independent from initial default output volume levels of the other audio signal sources 12.

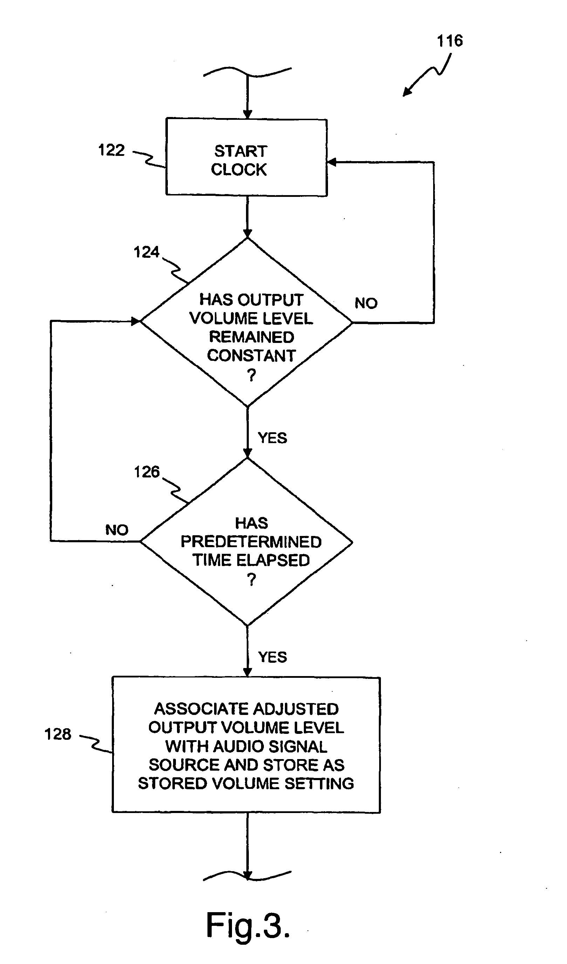

The process continues at decision block 114 where the controller 16 queries whether there has been a manual adjustment of the output volume level through the volume selector 24. If there has been a manual adjustment, the process continues at a volume setting sub-routine 116 as detailed below in connection with Figure 3. If there has been no manual adjustment of the output level, the process continues directly to decision block 118. At decision block 118, the controller 16 decides whether there has been a change of audio signal source 12 through the source selector 26. If there has been a change of audio signal source 12, the process returns to block 104, where the audio signal source 12 is identified. If there has been no change in audio signal source 12, then the process returns to decision block 114, where the controller 16 decides whether there has been a manual adjustment of the output volume level through the volume selector 24.

In one illustrative embodiment, at optional process block 120, the controller 16 may modify the output volume level of the output device 18 in response to external conditions as detected by one or more of the external condition sensors 32. For example, the volume of the output device 18 may be adjusted based upon input from one or more of the signal strength sensor 32a, the vehicle speed sensor 32b, the location sensor 32c, and the time sensor 32d.

Turning now to Figure 3, an illustrative volume setting sub-routine 116 is shown. When manual adjustment of the output volume level of the output device 18 is detected at block 114 (Figure 2), the sub-routine 116 is initiated by starting the clock 28 at block 122. At decision block 124, the controller 16 queries whether the output volume level of the output device 18 has remained constant. If the output volume level of the output device 18 has not remained constant, then the process returns to block 122 where the clock 28 is restarted. If the output volume level has remained constant, then the process continues to decision block 126 where the controller 16 queries whether a predetermined time, as determined by the clock 28, has elapsed. More particularly, the controller 16 decides whether predetermined number of time increments have been counted by the clock 28. If a predetermined time has not elapsed, then the process returns to decision block 124. If a predetermined time has elapsed, then the process continues to decision block 128, where the controller 16 associates the adjusted output volume level of the output device 18 with the audio signal source 12, and then stores this combination as a stored volume setting.

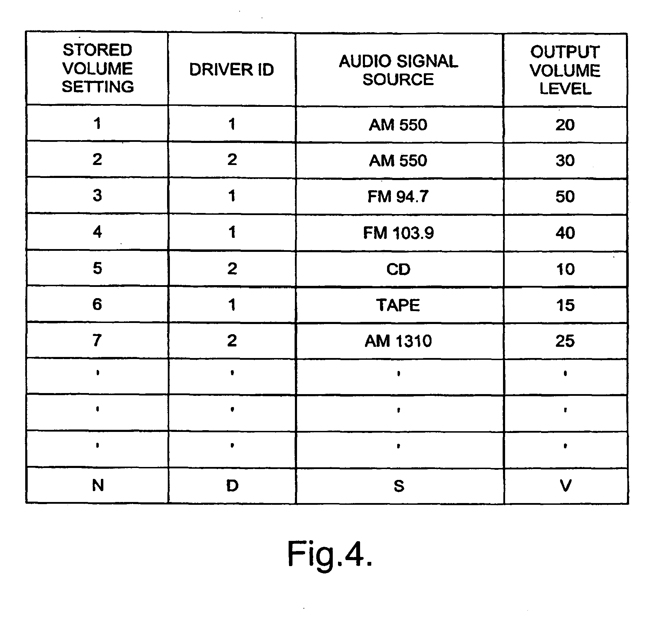

With reference to Figure 4, an illustrative table shows various exemplary stored volume settings, which are stored in the memory 22. These stored volume settings may be distinguished based upon driver identification, and associate audio signal sources 12 with output volume levels. Moreover, each stored volume setting has a separate output volume level associated therewith. For example, stored volume setting 1 is indexed to driver ID 1, audio signal source radio frequency AM 550, and has an associated output volume level of 20. Stored volume setting 2 is indexed to driver ID 2, audio signal source radio frequency AM 550, and has an associated output volume level of 30. Stored volume setting 3 is associated with driver ID 1, audio signal source radio frequency FM 94.7, and has an output volume level of 50. Stored volume setting 4 is associated with driver ID 1, audio signal source radio frequency FM 103.90, and has an output volume level of 40. Stored volume setting 5 is indexed with driver ID 2, a CD player, and has an output volume level of 10. Stored volume setting 6 is associated with driver ID 1, a tape player, and has an output volume level of 15. Finally, stored volume setting 7 is associated with driver ID 2, audio signal source radio frequency AM 1310, and has an output volume level of 25.

As noted above, each of the output levels of the stored volume settings may be modified as appropriate based upon certain external conditions. Sensors 32 for detecting such external conditions are known in the art. Further, while it is envisioned that the present invention will have particular applicability with audio systems within vehicles, the volume control system of the present invention is not limited thereto and may be utilized with home audio systems, televisions, etc.

## Claims

1. An audio volume control system (10) comprising:
an output device (18);
a clock (28);
a plurality of audio signal sources (12);
a source selector (26) coupled to the plurality of audio signal sources (12) and configured to connect one of the audio signal sources (12) to the output device (18) in response to input from a user;
a controller (20) coupled to the output device (18) and configured to identify the audio signal source (12) connected to the output device (18);
a memory (22) configured to store the identity of the audio signal source (12) connected to the output device (18) and the output volume level of the output device (18), as a stored volume setting for the audio signal source;
wherein the controller (20) is further configured to retrieve the stored volume setting for the audio signal source (12), and control the output volume level of the output device (18) in response to the stored volume setting;
wherein the controller (20) is further configured to decide if there has been a manual adjustment of the output volume level through a volume selector (24);
and wherein the controller (20) is further configured to associate and store, after the clock (28) has counted a predetermined number of increments, a manually adjusted output volume level of the output device (18) with the audio signal source (12), as the stored volume setting for the audio signal source.

2. The audio volume control system (10) of claim 1, further **characterized by** a volume selector (24) configured to control the output volume level of the output device (18) in response to input from a user.

3. The audio volume control system (10) of claim 1, **characterized in that** each of the plurality of audio signal sources (12) includes a common default output volume level.

4. The audio volume control system (10) of claim 1, **characterized in that** each of the plurality of audio signal sources (12) includes an initial default output volume level stored in the memory independent from other initial default output volume levels.

5. The audio volume control system (10) of claim 1, **characterized in that** the plurality of audio signal sources (12) includes at least two of a compact disc player (12a), a cassette tape player (12b), and a radio frequency received by a tuner.

6. The audio volume control system (10) of claim 1, **characterized in that** the plurality of audio signal sources (12) includes a plurality of radio frequencies received by a tuner.

7. The audio volume control system (10) of claim 1, further **characterized by** at least one external condition sensor (32) coupled to the controller (20) and configured to detect conditions external to the audio signal source (12).

8. The audio volume control system (10) of claim 7, **characterized in that** the external condition sensor (32) comprises at least one of a radio frequency signal strength sensor (32a), a vehicle speed sensor, a location sensor, and a time sensor.

9. The audio volume control system (10) of claim 8, wherein the radio frequency signal strength indicator (32a) is configured to detect the strength of an incoming wireless signal, and the controller (20) adjusts the output volume level of the output device (18) in response to the signal (34a) from the radio frequency signal strength indicator (32a).

10. A method of automatically controlling the volume produced by an audio system (10), the method **characterized by** the steps of:
selecting (102) a first audio signal source (12) configured to generate a first audio signal;
identifying (104) the first audio signal source (12);
controlling an output volume level (110) of an output device (18) in response to a first stored volume setting associating the first audio signal source (12) with a first output volume level;
selecting (118) a second audio signal source (12) configured to generate a second audio signal;
manually adjusting the output volume level (114) from the second audio signal source (12) to an adjusted output volume level;
determining elapsed time of constant value for the adjusted output volume level (124);
associating the adjusted output volume level with the second audio signal source (12) as a volume setting (128);
storing the volume setting as the second stored volume setting after a predetermined elapsed time has passed;
identifying (104) the second audio signal source (12); and
controlling an output volume level (110) of the output device (18) in response to a second stored volume setting associating the second audio signal source with a second output volume level.

11. The method of claim 10, further **characterized by** the steps of:
detecting a condition external to the second audio-signal source (12); and adjusting the output volume level from the second audio signal source (12) in response to the detected condition (120).

12. The method of claim 11, **characterized in that** the external condition comprises at least one of radio frequency signal strength, vehicle speed, location, and time.

13. The method of claim 10 further **characterized by** the steps of:
detecting the strength of an incoming wireless signal; and
adjusting the output volume level in response to the detected strength of the incoming wireless signal.

## Patentansprüche

1. Audiolautstärkesteuerungssystem (10), das aufweist:
eine Ausgabevorrichtung (18);
einen Taktgeber (28);
eine Vielzahl von Audiosignalquellen (12);
einen Quellen-Selektor (26), der mit der Vielzahl von Audiosignalquellen (12) verbunden ist und konfiguriert ist, eine der Audiosignalquellen (12) mit der Ausgabevorrichtung (18) zu verbinden in Reaktion auf eine Eingabe von einem Benutzer;
eine Steuervorrichtung (20), die mit der Ausgabevorrichtung (18) verbunden ist und konfiguriert ist, die Audiosignalquelle (12) zu identifizieren, die mit der Ausgabevorrichtung (18) verbunden ist;
einen Speicher (22), der konfiguriert ist, die Identität der Audiosignalquelle (12), die mit der Ausgabevorrichtung (18) verbunden ist, und den Ausgabelautstärkepegel der Ausgabevorrichtung (18) als eine gespeicherte Lautstärkeinstellung für die Audiosignalquelle zu speichern;
wobei die Steuervorrichtung (20) weiter konfiguriert ist, die gespeicherte Lautstärkeinstellung für die Audiosignalquelle (12) abzurufen und den Ausgabelautstärkepegel der Ausgabevorrichtung (18) in Reaktion auf die gespeicherte Lautstärkeinstellung zu steuern;
wobei die Steuervorrichtung (20) weiter konfiguriert ist, zu entscheiden, ob eine manuelle Anpassung des Ausgabelautstärkepegels durch einen Lautstärke-Selektor (24) stattgefunden hat;
und wobei die Steuervorrichtung (20) weiter konfiguriert ist, einen manuell angepassten Ausgabelautstärkepegel der Ausgabevorrichtung (18) zu der Audiosignalquelle (12) zuzuordnen und als die gespeicherte Lautstärkeeinstellung für die Audiosignalquelle zu speichern, nachdem der Taktgeber (28) eine vorgegebene Anzahl von Inkrementen gezählt hat.

2. Audiolautstärkesteuerungssystem (10) gemäß Anspruch 1, weiter **gekennzeichnet durch** einen Lautstärke-Selektor (24), der konfiguriert ist, den Ausgabelautstärkepegel der Ausgabevorrichtung (18) in Reaktion auf eine Eingabe von einem Benutzer zu steuern.

3. Audiolautstärkesteuerungssystem (10) gemäß Anspruch 1, **dadurch gekennzeichnet, dass** jede der Vielzahl von Audiosignalquellen (12) einen gemeinsamen Standard-Ausgabelautstärkepegel umfasst.

4. Audiolautstärkesteuerungssystem (10) gemäß Anspruch 1, **dadurch gekennzeichnet, dass** jede der Vielzahl von Audiosignalquellen (12) einen anfänglichen Standard-Ausgabelautstärkepegel umfasst, der in dem Speicher gespeichert ist, unabhängig von anderen anfänglichen Standard-Ausgabelautstärkepegeln.

5. Audiolautstärkesteuerungssystem (10) gemäß Anspruch 1, **dadurch gekennzeichnet, dass** die Vielzahl von Audiosignalquellen (12) zumindest zwei umfasst aus einem CD-Spieler (12a), einem Kassettenrekorder (12b) und einer Funkfrequenz, die durch einen Tuner empfangen wird.

6. Audiolautstärkesteuerungssystem (10) gemäß Anspruch 1, **dadurch gekennzeichnet, dass** die Vielzahl von Audiosignalquellen (12) eine Vielzahl von Funkfrequenzen umfasst, die durch einen Tuner empfangen werden.

7. Audiolautstärkesteuerungssystem (10) gemäß Anspruch 1, **gekennzeichnet durch** zumindest einen externen Bedingungssensor (32), der mit der Steuervorrichtung (20) verbunden ist und konfiguriert ist, Bedingungen zu erfassen, die extern zu der Audiosignalquelle (12) sind.

8. Audiolautstärkesteuerungssystem (10) gemäß Anspruch 7, **dadurch gekennzeichnet, dass** der externe Bedingungssensor (32) zumindest einen aufweist aus einem Funkfrequenzsignalstärkesensor (32a), einem Fahrzeuggeschwindigkeitssensor, einem Positionssensor und einem Zeitsensor.

9. Audiolautstärkesteuerungssystem (10) gemäß Anspruch 8, wobei der Funkfrequenzsignalstärkeindikator (32a) konfiguriert ist, die Stärke eines ankommenden drahtlosen Signals zu erfassen, und die Steuervorrichtung (20) den Ausgabelautstärkepegel der Ausgabevorrichtung (18) in Reaktion auf das Signal (34a) von dem Funkfrequenzsignalstärkeindikator (32a) anpasst.

10. Verfahren zum automatischen Steuern der Lautstärke, die durch ein Audiosystem (10) erzeugt wird, wobei das Verfahren die Schritte aufweist:
Auswählen (102) einer ersten Audiosignalquelle (12), die konfiguriert ist, ein erstes Audiosignal zu erzeugen;
Identifizieren (104) der ersten Audiosignalquelle (12); Steuern eines Ausgabelautstärkepegels (110) einer Ausgabevorrichtung (18) in Reaktion auf eine erste gespeicherte Lautstärkeeinstellung, welche die erste Audiosignalquelle (12) einem ersten Ausgabelautstärkepegel zuordnet;
Auswählen (118) einer zweiten Audiosignalquelle (12), die konfiguriert ist, ein zweites Audiosignal zu erzeugen;
manuelles Anpassen des Ausgabelautstärkepegels (114) von der zweiten Audiosignalquelle (12) auf einen angepassten Ausgabelautstärkepegel;
Bestimmen einer vergangenen Zeit eines konstanten Werts für den angepassten Ausgabelautstärkepegel (124);
Zuordnen des angepassten Ausgabelautstärkepegels zu der zweiten Audiosignalquelle (12) als eine Lautstärkeeinstellung (128);
Speichen der Lautstärkeeinstellung als die zweite gespeicherte Lautstärkeeinstellung, nachdem eine vorgegebene Zeitspanne vergangen ist;
Identifizieren (104) der zweiten Audiosignalquelle (12); und
Steuern eines Ausgabelautstärkepegels (110) der Ausgabevorrichtung (18) in Reaktion auf eine zweite gespeicherte Lautstärkeeinstellung, welche die zweite Audiosignalquelle (12) einem zweiten Ausgabelautstärkepegel zuordnet.

11. Verfahren gemäß Anspruch 10, das weiter **gekennzeichnet ist durch** die Schritte:
Erfassen einer Bedingung, die extern zu der zweiten Audiosignalquelle (12) ist; und
Anpassen des Ausgabelautstärkepegels von der zweiten Audiosignalquelle (12) in Reaktion auf die erfasste Bedingung (120).

12. Verfahren gemäß Anspruch 11, **dadurch gekennzeichnet, dass** die externe Bedingung zumindest eines aufweist aus einer Funkfrequenzsignalstärke, einer Fahrzeuggeschwindigkeit, einer Position und der Zeit.

13. Verfahren gemäß Anspruch 10, das weiter **gekennzeichnet ist durch** die Schritte:
Erfassen der Stärke eines ankommenden drahtlosen Signals; und
Anpassen des Ausgabelautstärkepegels in Reaktion auf die erfasste Stärke des ankommenden drahtlosen Signals.

## Revendications

1. Système de commande du volume de signaux audio (10) comprenant :
un dispositif de sortie (18) ;
une horloge (28) ;
une pluralité de sources de signaux audio (12) ;
un sélecteur de source (26) couplé à la pluralité de sources de signaux audio (12) et configuré pour connecter l'une des sources de signaux audio (12) au dispositif de sortie (18) en réponse à une entrée d'un utilisateur ;
un contrôleur (20) couplé au dispositif de sortie (18) et configuré pour identifier la source de signal audio (12) connectée au dispositif de sortie (18) ;
une mémoire (22) configurée pour stocker l'identité de la source de signal audio (12) connectée au dispositif de sortie (18) et le niveau du volume de sortie du dispositif de sortie (18), sous forme d'un réglage de volume stocké pour la source de signal audio ;
dans lequel le contrôleur (20) est en outre configuré pour récupérer le réglage de volume stocké pour la source de signal audio (12) et commander le niveau de volume de sortie du dispositif de sortie (18) en réponse au réglage de volume stocké ;
dans lequel le contrôleur (20) est en outre configuré pour décider s'il y a eu un ajustement manuel du niveau de volume de sortie via un sélecteur de volume (24) ;
et dans lequel le contrôleur (20) est en outre configuré pour associer et stocker, après que l'horloge (28) a compté un nombre prédéterminé d'incréments, un niveau de volume de sortie ajusté manuellement du dispositif de sortie (18) avec la source de signal audio (12), à titre de réglage de volume stocké pour la source de signal audio.

2. Système de commande du volume de signaux audio (10) selon la revendication 1, **caractérisé en outre par** un sélecteur de volume (24) configuré pour commander le niveau de volume de sortie du dispositif de sortie (18) en réponse à une entrée d'un utilisateur.

3. Système de commande du volume de signaux audio (10) selon la revendication 1, **caractérisé en ce que** chacune de la pluralité de sources de signaux audio (12) inclut un niveau de volume de sortie par défaut en commun.

4. Système de commande du volume de signaux audio (10) selon la revendication 1, **caractérisé en ce que** chacune de la pluralité de sources de signaux audio (12) inclut un niveau de volume de sortie par défaut initial stocké dans la mémoire indépendamment d'autres niveaux de volume de sortie par défaut initiaux.

5. Système de commande du volume de signaux audio (10) selon la revendication 1, **caractérisé en ce que** la pluralité de sources de signaux audio (12) inclut au moins deux sources parmi un lecteur de disques compacts (12a), un lecteur de bandes en cassette (12b), et une fréquence radio reçue par un tuner.

6. Système de commande du volume de signaux audio (10) selon la revendication 1, **caractérisé en ce que** la pluralité de sources de signaux audio (12) inclut une pluralité de fréquences radio reçues par un tuner.

7. Système de commande du volume de signaux audio (10) selon la revendication 1, **caractérisé en outre par** au moins un capteur de conditions externes (32) couplé au contrôleur (20) et configuré pour détecter des conditions externes à la source de signal audio (12).

8. Système de commande du volume de signaux audio (10) selon la revendication 7, **caractérisé en ce que** le capteur de conditions externes (32) comprend au moins un capteur parmi un capteur d'intensité du signal de fréquence radio (32a), un capteur de vitesse véhicule, un capteur de localisation, et un capteur de temps.

9. Système de commande du volume de signaux audio selon la revendication 8, dans lequel l'indicateur d'intensité du signal de fréquence radio (32a) est configuré pour détecter l'intensité d'un signal sans fil incident, et le contrôleur (20) ajuste le niveau de volume de sortie du dispositif de sortie (18) en réponse au signal (34a) provenant de l'indicateur d'intensité du signal de fréquence radio (32a).

10. Procédé pour commander automatiquement le volume produit par un système audio (10), le procédé étant **caractérisé par** les étapes consistant à :
choisir (102) une première source de signal audio (12) configurée pour générer un premier signal audio ;
identifier (104) la première source de signal audio (12) ; commander un niveau de volume de sortie (110) d'un dispositif de sortie (18) en réponse à un premier réglage de volume stocké qui associe la première source de signal audio (12) à un premier niveau de volume de sortie ;
choisir (118) une seconde source de signal audio (12) configurée pour générer un second signal audio ;
ajuster manuellement le niveau de volume de sortie (114) provenant de la seconde source de signal audio (12) à un niveau de volume de sortie ajusté ;
déterminer l'écoulement d'un temps de valeur constante pour le niveau de volume de sortie ajusté (124) ;
associer le niveau de volume de sortie ajusté à la seconde source de signal audio (12) à titre de réglage de volume (128) ;
stocker le réglage de volume à titre de second réglage de volume stocké après écoulement d'un temps prédéterminé ;
identifier (104) la seconde source de signal audio (12) ; et
contrôler un niveau de volume de sortie (110) du dispositif de sortie (18) en réponse à un second réglage de volume stocké associant la seconde source de signal audio à un second niveau de volume de sortie.

11. Procédé selon la revendication 10, **caractérisé en outre par** les étapes consistant à :
détecter une condition extérieure à la seconde source de signal audio (12) et
ajuster le niveau de volume de sortie provenant de la seconde source de signal audio (12) en réponse à la condition détectée (120).

12. Procédé selon la revendication 11, **caractérisé en ce que** la condition extérieure comprend au moins une condition parmi l'intensité d'un signal de fréquence radio, la vitesse véhicule, l'emplacement, et le temps.

13. Procédé selon la revendication 10, **caractérisé en outre par** les étapes consistant à :
détecter l'intensité d'un signal sans fil incident ; et
ajuster le niveau de volume de sortie en réponse à l'intensité détectée du signal sans fil incident.
